# EUROPÄISCHE PATENTSCHRIFT

(11) **EP 1 145 355 B1**
(45) Veröffentlichungstag und Bekanntmachung des Hinweises auf die Patenterteilung: **30.07.2003**
(21) Anmeldenummer: 99964621.9
(22) Anmeldetag: 21.12.1999
(51) Int. Cl.: H01M 10/48, G01R 31/36

(54) **VERFAHREN UND ANORDNUNG ZUR STROMMESSUNG AN EINER BATTERIEZELLE**
METHOD AND ARRANGEMENT FOR MEASURING CURRENT ON A STORAGE BATTERY CELL
PROCEDE ET DISPOSITIF DE MESURE D'INTENSITE SUR UN ELEMENT D'ACCUMULATEUR

(30) Priorität: 22.12.1998 DE 19860561
(43) Veröffentlichungstag der Anmeldung: 17.10.2001
(73) Patentinhaber: IMMS GGmbH, 98693 Ilmenau (DE)
(72) Erfinder: KORNETZKY, Peter, D-98693 Ilmenau (DE)
(74) Vertreter: Hengelhaupt, Jürgen, Dipl.-Ing.
(86) Internationale Anmeldenummer: EP9910162
(87) Internationale Veröffentlichungsnummer: WO00039880

(56) Entgegenhaltungen:
- EP-A- 0 568 767
- US-A- 3 720 869
- US-A- 3 793 078
- US-A- 4 126 735
- PATENT ABSTRACTS OF JAPAN vol. 011, no. 117 (E-498), 11. April 1987 (1987-04-11) & JP 61 264687 A (YUASA BATTERY CO LTD), 22. November 1986 (1986-11-22)
- PATENT ABSTRACTS OF JAPAN vol. 016, no. 574 (E-1298), 14. Dezember 1992 (1992-12-14) -& JP 04 223064 A (SHIN KOBE ELECTRIC MACH CO LTD), 12. August 1992 (1992-08-12)
- PATENT ABSTRACTS OF JAPAN vol. 017, no. 036 (P-1474), 22. Januar 1993 (1993-01-22) & JP 04 254779 A (SHIN KOBE ELECTRIC MACH CO LTD), 10. September 1992 (1992-09-10)

## Beschreibung

Die Erfindung betrifft ein Verfahren und eine Anordnung zur Strommessung an einer Batteriezelle mit mindestens zwei flächenhaften Sammelelektroden gemäß dem Oberbegriff der Ansprüche 1 und 2.

Die Messung des Stromes an Batteriezellen wie Primärbatterien und Akkumulatoren dient der Detektierung von verschiedenen Betriebszuständen wie Überlastzuständen, zur Regelung elektrischer Betriebsparameter, einschließlich der Parameter zum Betrieb der Batterie selbst, zur Bewertung von Ladezuständen und dergleichen.

Es sind unterschiedliche Möglichkeiten zur Messung des Stromes außerhalb der Batteriezellen entsprechend den zu erwartenden Stromstärken bekannt:
1. Strommesswiderstände, bei denen die darüber gemessene Spannungsdifferenz bewertet wird (Frühauf,U.: Grundlagen der elektronischen Messtechnik, Akademische Verlagsgesellschaft Geest & Portig KG, Leipzig 1977, Seite 154).
2. Stromsensoren, die das von einem stromdurchflossenen Leiter erzeugte Magnetfeld in eine elektrisch messbare Größe umwandeln( zum Beispiel Hallsensoren)(Applikationsschrift "Galvanisch getrennte Strom- und Spannungswandler Eigenschaften-Anwendungen-Dimensionierung", LEM Unternehmens-Kommunikation, Genf 1996).
3. Halbleiterbauelemente, die einen Teil des durch sie fließenden Stromes durch Stromteilung auf einem niedrigeren Niveau messbar gestalten (zum Beispiel SENSFET Bauelemente)(Produktbeschreibung der Siemens AG "Sense Highside Switch in Smart Power Technology takes over Fuse Function"
   -http://www.infineon.com/products/36/36.htm).

Insbesondere bei der Messung sehr hoher Ströme, wie sie zum Beispiel beim Betrieb von Kraftfahrzeugen oder bei der Stromversorgung von energieintensiven Baugruppen auftreten, führt die Strommessung mit den Mitteln entsprechend den aufgeführten Punkten zu unerwünschten, zusätzlichen Energieverlusten bzw. zu Problemen bei der Nullpunktstabilität und der Messgenauigkeit.

Aus der DE 42 15 124 A1 ist ein Verfahren zur Bestimmung des Ladezustandes einer elektrochemischen Zelle durch Messen der Leitfähigkeit eines der aktiven Zellenbestandteile bekannt. Die Leitfähigkeit bzw. der elektrische Widerstand des aktiven Materials einer Elektrode ändert sich mit dem Umsetzungsgrad der stromliefernden Reaktion, sofern der Elektrolyt nicht nur als Transportmedium für die Ionenströme fungiert.

Das Verfahren setzt voraus, dass der Elektrolyt, wie zum Beispiel die Schwefelsäure in Bleiakkumulatoren, selbst als aktives Material an der elektrochemischen Reaktion beteiligt ist.

Aus der US 3 720 869 ist es bekannt, den Ladezustand einer Batteriezelle zu bestimmen, indem der Widerstand des aktiven Elektrodenmaterials für die Größe der zu messenden Spannung herangezogen wird.

Der Erfindung liegt die Aufgabe zugrunde, ein gattungsgemäßes Verfahren und eine Anordnung zu entwickeln, mit denen die Mängel der bekannten Einrichtungen vermieden werden und mit denen eine preiswerte, schnelle und zuverlässige Strommessung ohne unerwünschte, zusätzliche Energieverluste bei hoher Messgenauigkeit und Nullpunktstabilität sowie ohne die Notwendigkeit des Vorhandenseins eines aktiven Elektrolyts gewährleistet werden.

Erfindungsgemäß wird diese Aufgabe durch die Merkmale der Ansprüche 1 und 2 gelöst. Danach wird die Spannungsdifferenz zwischen einem im Randbereich einer der Sammelelektroden angeordneten nichtkontaktierten Abschnitt und einem verbleibenden, mittels einer elektrisch leitfähigen Schicht kontaktierten Bereich der gleichen Sammelelektrode gemessen.

Die Anordnung zur Strommessung an einer Batteriezelle mit mindestens zwei flächenhaften Sammelelektroden und damit elektrisch leitfähig verbundenen Anschlusselektroden zur Stromentnahme, zeichnet sich dadurch aus, dass zur Kontaktierung der Elektroden am Rande eine elektrisch leitfähigen Schicht vorgesehen ist, wobei an diesem Rande in einem Abschnitt definierter Länge diese elektrisch leitfähige Schicht fehlt, und dass die Anschlusselektroden über eben diese elektrisch leitfähige Schicht mit den Elektroden leitend verbunden sind, und wobei die zusätzliche Anschlusselektrode an einen nichtkontaktierten Abschnitt einer der flächenhaften Sammelelektroden vorgesehen ist.

Es können insbesondere hohe Ströme ohne zusätzliche Energieverluste direkt an der betreffenden Batteriezelle gemessen werden, wobei Konstruktionselemente der Batteriezelle zur Messung angewendet werden, die ohnehin zum Betrieb der Batteriezelle notwendig sind. Der Aufwand zur Realisierung des Verfahrens ist gering.

Der Zusammenhang zwischen der gemessenen Spannungsdifferenz und dem berechneten Strom besteht unabhängig vom Ladezustand der Batteriezelle.

Vorteilhafte Weiterbildungen der Erfindung ergeben sich aus den Unteransprüchen.

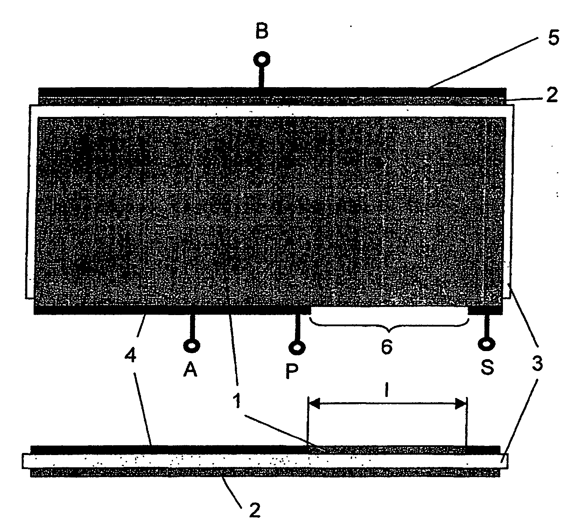

Die Erfindung soll nachstehend anhand einer Zeichnung an einem Ausführungsbeispiel einer Anordnung zur Strommessung näher erläutert werden. Die einzige Figur zeigt die schematische Darstellung des prinzipiellen Aufbaus einer Wickelbatterie, zum Beispiel einer Lithium-Ionen-Batteriezelle.

Die Batteriezelle besteht aus zwei Metallfolien 1, 2, im Ausführungsbeispiel Aluminium und Kupfer, die mit entsprechenden Beschichtungen versehen sind und jeweils eine flächenhafte Sammelelektrode darstellen, und zwischen denen sich ein Elektrolyt 3 befindet. Die beiden Folien 1,2 sind seitlich versetzt übereinander angeordnet und können flach angeordnet oder als ein Zylinder (Wickel) aufgewickelt sein.

Zur besseren Verständlichkeit der Wirkungsweise der Strommessung ist hier eine flache Folienanordnung dargestellt.

Im Falle einer Wickelanordnung werden die beiden Metallfolien 1, 2 an den Stirnseiten des nicht dargestellten Wickels durch ein großflächiges Aufbringen einer Metallschicht oder auf andere Art und Weise so kontaktiert, dass der zu der Batteriefläche (überlappender Teil der beiden Elektroden 1, 2) fließende Strom auf möglichst kurzem Wege an den Anschlusselektroden A und B abgegriffen werden kann. Die Vorzugsrichtung des Stromflusses ist dabei entlang der Längsachse des Batteriewickels.

Nach der vorliegenden Erfindung wird das letzte Stück der Folie 1 am Rand nicht mit einem Stromabgriff A versehen, so dass der von den Flächenelementen des letzten Metallfolienabschnitts 6 der Metallfolie 1 generierte bzw. aufgenommene Strom erst über einen Teil des nichtkontaktierten Folien-abschnitts 6 der Länge 1 quer zur Hauptstromrichtung fließt und dabei eine Spannungsdifferenz zwischen der Anschlusselektrode A und einer zusätzlich angebrachten Anschlusselektrode S (Sens-Elektrode) erzeugt. Durch die geeignete Dimensionierung der Länge 1 des nicht-kontaktierten Abschnittes 6 wird der Größenbereich der zu messenden Spannungsdifferenz bestimmt.

Unter der Voraussetzung, dass der von dem Abschnitt 6 beigetragene Stromanteil in einem aus der geometrischen Größe des Batteriewickels und den elektrischen Eigenschaften der verwendeten Materialien berechenbaren Verhältnis zum Gesamtstrom steht, kann aus der gemessenen Spannungsdifferenz auf den Gesamtstrom der Batteriezelle geschlossen werden.

Da die Spannung lediglich an einem kleinen Anteil des Gesamtstromes gemessen wird, ist die generierte Verlustleistung reduziert und gering. Die Dimensionierung des zusätzlichen Anschlusskontaktes S erfolgt unter Berücksichtigung der elektrischen Eigenschaften der verwendeten Konstruktionsmaterialien und bestimmt zusammen mit der Dimensionierung der Länge 1 des nichtkontaktierten Abschnitts 6 der jeweiligen Metallfolie 1, 2 den Größenbereich der Spannungsdifferenz zwischen den Kontakten A und S.

Die geometrische Anordnung der zusätzlichen Anschlusselektrode S kann auch an der gegenüber der Anschlusselektrode A liegenden Seite der Metallfolie 1 kontaktiert werden. Die kontaktfreie Zone 6 kann auch an einer anderen Position entlang der kontaktierten Randzone der Metallfolie 1 angeordnet sein, wobei die zusätzliche Anschlusselektrode S vorzugsweise in der Mitte der kontaktfreien Zone 6 angebracht wird.

Zur Kompensation der Spannungsabfälle entlang der Kontaktierungsschicht 4 bis zur Anschlusselektrode A kann eine zusätzliche Elektrode P angebracht sein, um das Potential der Kontaktierungsschicht 4 weitgehend unabhängig von dem durch sie fließenden Strom zu erfassen.

### Bezugszeichenliste

- 1: Sammelelektrode (Metallfolie)
- 2: Sammelelektrode (Metallfolie)
- 3: Elektrolyt
- 4: Metallschicht (Kontaktierungsschicht von 1)
- 5: Metallschicht (Kontaktierungsschicht von 2)
- 6: Abschnitt

- A: Anschlusselektrode
- B: Anschlusselektrode
- P: weitere Anschlusselektrode
- S: Anschlusselektrode (Sens-Elektrode)

- 1: Länge

## Patentansprüche

1. Verfahren zur Strommessung an einer Batteriezelle mit mindestens zwei flächenhaften Sammelelektroden und damit elektrisch leitfähig verbundenen Anschlusselektroden zur Stromentnahme, wobei die elektrische Spannungsdifferenz zwischen einer zusätzlichen Anschlusselektrode (S) und der zugehörigen Anschlusselektrode (A, B) des jeweils übrigen Teils der flächenhaften Sammelelektrode (1, 2) gemessen und daraus der Gesamtstrom bestimmt wird,
**dadurch gekennzeichnet, dass**
die Spannungsdifferenz zwischen einem im Randbereich einer der Sammelelektroden (1, 2) angeordneten nichtkontaktierten Abschnitt (6) und einem verbleibenden, mittels einer elektrisch leitfähigen Schicht (4) kontaktierten Bereich der gleichen Sammelelektrode (1, 2) gemessen wird.

2. Anordnung zur Strommessung an einer Batteriezelle mit mindestens zwei flächenhaften Sammelelektroden und damit elektrisch leitfähig verbundenen Anschlusselektroden zur Stromentnahme, wobei ein Abschnitt (6) der flächenhaften Sammelelektroden (1, 2) kontaktierungsfrei ausgeführt ist und eine zusätzliche Anschlusselektrode (S) vorgesehen ist, wobei der verbleibende Teil der Sammelelektrode (1, 2) mit einer Anschlusselektrode (A,B) versehen ist,
**dadurch gekennzeichnet, dass**
zur Kontaktierung der Elektroden (1, 2) am Rande eine elektrisch leitfähige Schicht (4) vorgesehen ist, wobei an diesem Rande in einem Abschnitt (6) definierter Länge (1) diese elektrisch leitfähige Schicht (4) fehlt, und dass die Anschlusselektroden (A,B) über eben diese elektrisch leitfähige Schicht (4) mit den Elektroden (1, 2) leitend verbunden sind, und wobei die zusätzliche Anschlusselektrode (S) an den nichtkontaktierten Abschnitt (6) einer der flächenhaften Sammelelektroden (1, 2) angeordnet ist.

3. Anordnung nach Anspruch 2, **dadurch**
**gekennzeichnet, dass** die zusätzliche Anschlusselektrode (S) auf der Seite der Anschlusselektrode (A, B) für den jeweils verbleibenden Teil der Sammelelektrode (1, 2) oder dieser gegenüberliegend angeordnet ist.

4. Anordnung nach Anspruch 2, **dadurch**
**gekennzeichnet, dass** der kontaktierungsfreie Abschnitt (6) der jeweiligen Sammelelektrode (1, 2) etwa in der Mitte und die zusätzliche Anschlusselektrode (S) etwa in der Mitte des kontaktierungsfreien Abschnitts (6) angeordnet ist.

5. Anordnung nach den Ansprüchen 3 und 4, **dadurch**
**gekennzeichnet, dass** die Anschlusselektrode (A, B) über eine weitere Anschlusselektrode (P) zusätzlich kontaktiert ist.

## Claims

1. Method for the current measurement on a battery cell with at least two areal collector electrodes and, subsequently, electrically conductively joined connecting electrodes for current extraction, where the electrical voltage difference between an additional connecting electrode (S) and the relevant connecting electrode (A, B) of the remaining part, in each case, of the areal collecting electrode (1, 2) is measured and the overall current is determined therefrom,
**wherein**
the voltage difference between a non-contacting section (6) arranged in the peripheral zone of one of the collector electrodes (1, 2) and a remaining contacting area of the same collector electrode (1, 2) by means of an electrically conductive layer (4) is measured.

2. Arrangement for current measurement on a battery cell with at least two areal collector electrodes and, subsequently, electrically conductively joined connecting electrodes for current extraction, where one section (6) of the areal collector electrodes (1, 2) is executed in a contacting-free manner and an additional connecting electrode (S) is envisaged, where the remaining part of the collector electrode (1, 2) is provided with a connecting electrode (A, B),
**wherein,**
for the contacting of the electrodes (1, 2) at the periphery, an electrically conductive layer (4) is envisaged where, at this periphery in a section (6) of defined length (1), this electrically conductive layer (4) is missing, and the connector electrodes (A, B) are conductingly connected by way of just this electrically conductive layer (4) with the electrodes (1, 2), and where the additional connector electrode (S) is arranged at the non-contacting section (6) of the areal collector electrodes (1, 2).

3. Arrangement according to Claim 2, wherein
the additional connecting electrode (S) is arranged on the side of the connecting electrode (A, B) for the remaining part, in each case, of the collector electrode (1, 2) or is arranged opposite to this.

4. Arrangement according to Claim 2, wherein
the contacting-free section (6) of the respective collector electrode (1, 2) is arranged approximately in the middle and the additional connecting electrode (S) is arranged in the middle of the contacting-free section (6).

5. Arrangement according to Claims 3 and 4, wherein
the connecting electrode (A, B) is additionally contacted by way of a further connecting electrode (P).

## Revendications

1. Procédé pour mesurer le courant sur une cellule de batterie avec au moins deux électrodes collectrices planes et des électrodes de connexion reliées audites électrodes collectrices de manière à conduire l'électricité; la différence de tension électrique entre une électrode de connexion (S) supplémentaire et l'électrode de connexion associée (A, B) de la partie restante respective des électrodes collectrices (1, 2) planes étant mesurée et le courant total étant déterminé à partir de cette différence,
**caractérisé en ce qu'**on calcule la différence de tension entre un tronçon (6) non contacté disposé dans la zone de bord d'une des électrodes collectrices (1, 2) et une zone contactée restante des mêmes électrodes collectrices (1, 2) au moyen d'une couche (4) conductrice d'électricité.

2. Disposition pour mesurer l'électricité sur une cellule de batterie avec au moins deux électrodes collectrices planes et des électrodes de connexion reliées audites électrodes collectrices de manière à conduire l'électricité destinée à l'alimentation en courant; un tronçon (6) des électrodes collectrices (1, 2) planes étant réalisé sans contact et une électrode de connexion (S) supplémentaire étant prévue ; la partie restante de l'électrode collectrice (1, 2) étant pourvue avec une électrode de connexion (A, B),
**caractérisé en ce que**,
une couche (4) conductrice d'électricité est prévue sur le bord pour contacter les électrodes (1, 2); cette couche (4) conductrice d'électricité manquant sur ce bord dans un tronçon (6) de longueur définie (1) et **caractérisé en ce que** les électrodes de connexion (A, B) sont reliés par cette couche (4) conductrice d'électricité aux électrodes (1, 2) et où l'électrode de connexion (S) supplémentaire est disposée sur le tronçon (6) qui ne contacte pas d'une électrode collectrice (1, 2) plane.

3. Disposition selon la revendication 2, **caractérisée en ce que** l'électrode de connexion (S) supplémentaire est disposée sur le côté de l'électrode de connexion (A, B) pour la partie restante respective de l'électrode collectrice (1, 2) ou située en face de ladite électrode.

4. Disposition selon la revendication 2, **caractérisée en ce que** le tronçon (6) libre de contact de chaque électrode collectrice (1, 2) est disposé environ au milieu et que l'électrode de connexion (S) supplémentaire est disposée environ au milieu du tronçon (6) libre de contact.

5. Disposition selon les revendications 3 et 4, **caractérisé en ce que** l'électrode de connexion (A, B) est contactée en plus par une autre électrode de connexion (P).
